# DEMANDE DE BREVET EUROPEEN

(11) **EP 2 871 595 A1**
(43) Date de publication de la demande: **13.05.2015**
(21) Numéro de dépôt: 13306540.9
(22) Date de dépôt: 12.11.2013
(51) Int. Cl.: G06K 19/077

(54) **Carte à puce comprenant un module électronique électriquement connecté à un circuit électrique**

(71) Demandeur: Gemalto SA, 92190 Meudon (FR)
(72) Inventeur: Poitrasson, Eric, 13705 La Ciotat (FR); Torrado, Antonio, 13705 La Ciotat (FR); Guijarro, Sébastien, 13705 La Ciotat (FR)

(57) **Abrégé**

L'invention porte sur une carte à puce comprenant un corps de carte (10) dans lequel est encarté un module électronique électriquement connecté à un circuit électrique (20) noyé dans ledit corps de carte, ladite carte étant caractérisée en ce que la connexion électrique entre le module électronique et le circuit électrique comprend un plot (41) de mousse électriquement conductrice. Le plot de mousse résiste très bien aux contraintes de flexion et /ou de torsion.

## Description

L'invention concerne le domaine des cartes à puce. Plus particulièrement, elle concerne une carte à puce comprenant un module électronique électriquement connecté à un circuit électrique noyé dans le corps de carte.

L'invention s'applique notamment, mais non exclusivement, aux cartes dites « dual interface » ou « combi », qui comprennent deux interfaces de communication, une première interface apte à communiquer grâce à des plages de contact externes au format ISO7816 et affleurant la surface de la carte, et une deuxième interface apte à communiquer sans contact selon la norme ISO14443 grâce à une antenne de communication radio fréquence noyée dans le corps de carte. L'invention s'applique également aux cartes dites « interconnectées » comprenant un circuit électrique noyé dans le corps de carte. Une telle carte peut par exemple être une carte à afficheur, généralement utilisée dans le secteur bancaire, qui dispose d'un circuit imprimé supportant des composants électroniques et notamment un microcontrôleur, un écran, une batterie et un ou plusieurs boutons poussoirs pour communiquer avec le porteur de carte. Plus particulièrement, le microcontrôleur du circuit imprimé permet de lire des informations contenues dans la puce, et notamment les dernières transactions ayant eu lieu, et de les afficher sur l'écran.

On entend par module électronique, une puce de circuit intégré fixée sur la face cachée d'une grille de connexion au moyen d'un adhésif. Les plots de la puce de circuit intégré sont électriquement connectés aux plages de contact de la grille de connexion au moyen de fils dorés. Pour pouvoir relier électriquement le module électronique à un autre circuit électrique noyé dans le corps de carte, le module comprend en outre une paire de plages de contact internes, disposées sur la face cachée de la grille de connexion. Chacune de ces plages de contact est électriquement reliées à un plot de contact de la puce de circuit intégré au moyen d'un fil doré. Les fils de connexion et la puce de circuit intégré sont ensuite encapsulés dans une résine de protection.

Une cavité est creusée dans le corps de carte pour y insérer le module électronique. Lorsque la carte est une carte combi, la cavité est creusée de telle sorte qu'elle permet d'exposer les pistes de connexion de l'antenne à motif spiralé qui est noyée dans le corps de carte. Pour cela, la cavité est creusée de manière à former deux cavités concentriques. Une première cavité, de diamètre inférieur et plus profonde, permet d'y loger la puce de circuit intégré et les fils de connexion enrobés dans la résine de protection, tandis que la deuxième cavité, de diamètre supérieur à la première et moins profonde, permet d'y loger la grille de connexion et de réaliser la connexion électrique entre les plages de contacts internes du module électronique et les pistes de connexion de l'antenne.

Pour réaliser cette connexion entre le module électronique et les pistes de connexion de l'antenne, on utilise généralement des bossages conducteurs, encore dénommés « bumps » ou de la colle à argent. Que ce soit les bossages conducteurs ou la colle à argent, ils sont réalisés par dispense d'une résine liquide, en général de type epoxy, contenant des particules d'argent, qui polymérise à une certaine température. Or, le temps de polymérisation de ces résines est long, en moyenne de l'ordre de 24 heures. De plus, étant donné qu'elles sont dispensées sous forme liquide, elles ont tendance à déborder autour des pistes de connexion. La résine époxy polymérisée manque de souplesse, si bien qu'elle résiste mal aux contraintes de flexion et de torsion. Enfin, la polymérisation de la résine entraine un phénomène de retrait pouvant engendrer l'apparition de contraintes. L'apparition de ces contraintes, associée au fait que la résine polymérisée manque de souplesse, augmente le risque de rupture de la connexion électrique lorsque la carte est soumise à des contraintes de flexion et/ou de torsion répétées.

L'invention a donc pour but de remédier à au moins un des inconvénients de l'art antérieur. En particulier, l'invention vise à proposer une carte comprenant un module électronique électriquement connecté à un circuit électrique noyé dans le corps de carte, dont la connexion électrique est suffisamment souple et robuste pour supporter des contraintes de flexion et/ou de torsion.

A cet effet, l'invention a pour objet une carte à puce comprenant un corps de carte dans lequel est encarté un module électronique électriquement connecté à un circuit électrique noyé dans ledit corps de carte, ladite carte étant **caractérisée en ce que** la connexion électrique entre le module électronique et le circuit électrique comprend un plot de mousse électriquement conductrice.

Ainsi, la mousse présente une souplesse suffisante pour permettre au plot de résister aux contraintes de flexion et de torsion, de sorte que la connexion électrique n'est pas rompue. De plus, le plot de mousse qui est reporté est solide, si bien qu'il conserve sa forme d'origine et aucune contrainte supplémentaire susceptible de nuire à l'interconnexion électrique n'apparait après son report. Le plot est facile et rapide à reporter, et il n'y a plus de nécessité d'attendre une polymérisation.

Selon d'autres caractéristiques optionnelles de la carte :
- la mousse électriquement conductrice est à base d'élastomère conducteur comprenant l'un au moins des matériaux conducteurs suivants : carbone graphite, cuivre argenté, nickel, graphite nickelé, aluminium argenté ou polymères conducteurs tels que des polyacétylènes ou des polypyrroles,
- l'élastomère de constitution de la mousse conductrice est un silicone ou un silicone fluoré,
- le plot de mousse électriquement conductrice présente une épaisseur comprise entre 0,1 et 0,5mm,
- le plot de mousse électriquement conductrice présente un diamètre compris entre 0,5 et 1,5 mm,
- le circuit électrique noyé dans le corps de carte est une antenne ou un circuit imprimé supportant au moins un autre composant électronique.

L'invention se rapporte en outre à un procédé de fabrication d'une carte à puce comprenant un corps de carte dans lequel est encarté un module électronique électriquement connecté à un circuit électrique noyé dans ledit corps de carte, ledit procédé consistant à ménager une cavité dans le corps de carte, prévue pour y loger le module électronique, au-dessus de pistes de connexion dudit circuit électrique à interconnecter, ledit procédé étant **caractérisé en ce qu'il** consiste à reporter un plot de mousse électriquement conductrice sur chaque piste de connexion dudit circuit électrique puis à reporter ledit module électronique dans sa cavité de sorte que ses plages de contact internes soient électriquement reliées aux pistes de connexion du circuit électrique via les plots de mousse conductrice.

Selon d'autres caractéristiques optionnelles du procédé :
- préalablement au report du plot de mousse électriquement conductrice, le plot est prédécoupé dans un rectangle ou un cylindre de mousse conductrice,
- le plot de mousse conductrice est fixé sur les pistes de connexion du circuit électrique par l'un au moins des moyens suivants : apport de chaleur, dispense d'un adhésif électriquement conducteur ou fixation mécanique.

D'autres particularités et avantages de l'invention apparaitront à la lecture de la description suivante faite à titre d'exemple illustratif et non limitatif, en référence aux Figures annexées qui représentent :

La Figure 1, un schéma en coupe d'une combi-carte,

La Figure 2, un schéma en coupe d'une carte interconnectée

Les Figures 3A et 3B, des schémas de mousses électriquement conductrices prédécoupées sous forme de plots destinés à être reportés sur les pistes de connexion du circuit électrique embarqué dans le corps de carte.

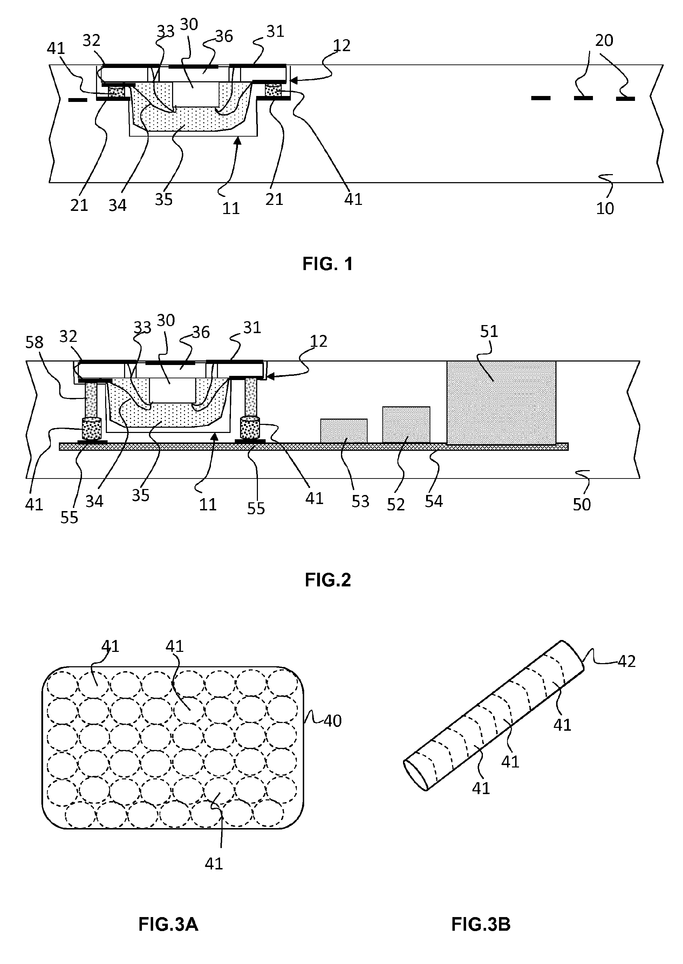

La Figure 1 schématise une combi-carte vue en coupe. Cette carte comprend un corps 10 généralement constitué de plusieurs couches plastiques superposées. Dans le corps de carte est ménagée une double cavité 11, 12 prévue pour y loger le module électronique. Le module électronique comprend une puce de circuit intégré référencée 30 dont les plots sont électriquement reliés d'une part, à des plages de contact 31 d'une grille de connexion affleurant la surface externe du corps de carte et d'autre part, à des plages de contact internes 32 disposées sur la face cachée de la grille de connexion. La gille de connexion est supportée par un matériau diélectrique 36 sur lequel la puce de circuit intégré 30 est fixée par collage. Les connexions de la puce 30 aux différentes plages de contact 31, 32 de la grille de connexion sont réalisées au moyen de fils dorés référencés respectivement 33, 34. La puce de circuit intégré 30 et les fils dorés 33, 34 sont enrobés dans une résine de protection 35.

La double cavité 11, 12 ménagée dans le corps de carte 10 présente une première cavité, de diamètre inférieur et plus profonde que la deuxième, prévue pour y loger la puce de circuit intégré 30 enrobée dans sa résine de protection 35. La deuxième cavité 12 concentrique, de diamètre supérieur et moins profonde que la première, permet d'y loger la grille de connexion. Cette deuxième cavité 12 est creusée de manière à exposer les pistes de connexion 21 du circuit électrique 20, noyé dans le corps de carte 10, à raccorder au module électronique. Dans cet exemple, le circuit électrique est une antenne 20 à motif spiralé. Les pistes 21 de connexion de l'antenne 20 débouchent dans la cavité. Un plot de mousse électriquement conductrice 41 est alors disposé, au moyen d'une machine de report automatique, sur chaque piste 21 de connexion de l'antenne 20, avant le report du module électronique, afin de permettre l'établissement d'une connexion électrique entre les pistes de connexion 21 de l'antenne et les plages de contact internes 32 du module électronique.

Un autre exemple d'application est illustré sur le schéma en coupe de la Figure 2 qui représente une carte 50 interconnectée comprenant un support flexible 54 sur lequel est imprimé un circuit électrique et supportant des composants électriques 51, 52, 53 parmi lesquels un afficheur 51. Le module est identique à celui de la Figure 1 et les mêmes références sont utilisées pour désigner les mêmes éléments. Dans ce mode de réalisation, les composants électroniques 51, 52, 53 étant très épais, le support flexible 54 est disposé près de la surface de la carte opposée à la surface portant les plages de contact 31 de la grille de connexion du module. Par conséquent, lors de la réalisation de la double cavité, il n'est pas possible de faire déboucher, dans la cavité 12, les pistes de connexion 55 du circuit électrique imprimé. Les plots de mousse électriquement conductrice 41 sont donc reportés sur les pistes de connexion 55 du circuit imprimé avant sa mise en place dans le corps de carte. Puis la double cavité 11, 12 est creusée dans le corps 50 de carte et des puits 58 sont ménagés au droit des plots de mousse électriquement conductrice 41, puis remplis de matériau conducteur, afin d'assurer une interconnexion électrique entre les pistes de connexion 55 du circuit imprimé et les plages de contacts interne 32 du module électronique.

La mousse électriquement conductrice présente une souplesse suffisante pour résister aux contraintes de flexion et de torsion. Elle peut par exemple être réalisée à partir d'une mousse de polyuréthane chargée de particules conductrices. De préférence, les plots de mousse conductrice 41 sont réalisés à base d'élastomère conducteur. L'élastomère, qui est de préférence un silicone ou un silicone fluoré, joue alors le rôle de liant, et il comprend des charges conductrices choisies parmi l'un au moins des matériaux conducteurs suivants : carbone graphite, cuivre argenté, nickel, graphite nickelé, aluminium argenté ou polymères conducteurs tels que des polyacétylènes ou des polypyrroles. De telles mousses électriquement conductrices sont par exemple commercialisées par la société Kemtron, sous les références SNG VMQ, SSA VMQ, ou FSA VMQ par exemple.

Les Figures 3A et 3B schématisent les formes sous lesquelles les mousses électriquement conductrices se présentent. Ces mousses se présentent soit sous forme de rectangle 40 (Figure 3A), soit sous forme de cylindre 42 (Figure 3B). Pour pouvoir être utilisées et reportées de manière automatique sous forme de plots dans une carte à puce, ces mousses sont adaptées. Elles sont notamment prédécoupées au format du plot à reporter dans la carte. Les prédécoupes sont réalisées au moyen d'un poinçon adapté. Elles sont représentées en traits pointillés sur les Figures 3A et 3B. Une machine automatique de report classiquement utilisée dans les procédés de fabrication des cartes à puce est alors utilisée pour reporter chaque plot de mousse électriquement conductrice sur la piste de connexion qui lui est dédiée.

Les mousses sont avantageusement prédécoupées de telle sorte que les plots à reporter dans un même lot de cartes présentent tous la même dimension. Selon les cartes auxquelles ils sont destinés, les plots de mousse électriquement conductrice présentent avantageusement une épaisseur comprise entre 0,1 et 0,5mm et un diamètre compris entre 0,5 et 1,5 mm.

Un plot de mousse conductrice peut être fixé sur une piste de connexion par tout moyen approprié comme par exemple une dispense préalable d'un adhésif conducteur sur la mousse ou sur la piste de connexion, ou par un apport de chaleur permettant de fixer le plot sur la piste de connexion par soudure. Il peut aussi être fixé mécaniquement par ancrage sur une excroissance prévue sur les plages de contact internes 32 du module électronique par exemple.

Le liant élastomère constitutif de la mousse électriquement conductrice conserve ses propriétés élastomères sur une large plage de température comprise entre -55°C et +160°C, ce qui confère au plot de mousse électriquement conductrice une bonne résistance à la flexion et à la torsion.

Le plot reporté est solide. Il n'y a donc pas de problème de débordement de résine s'écoulant autour des pistes de connexion, ni de temps d'attente pour une polymérisation. L'interconnexion entre le module électronique et le circuit électrique avec un tel plot est donc facile et rapide à mettre en oeuvre.

## Revendications

1. Carte à puce comprenant un corps de carte (10, 50) dans lequel est encarté un module électronique électriquement connecté à un circuit électrique (20, 55) noyé dans ledit corps de carte, ladite carte étant **caractérisée en ce que** la connexion électrique entre le module électronique et le circuit électrique comprend un plot (41) de mousse électriquement conductrice.

2. Carte à puce selon la revendication 1, **caractérisée en ce que** la mousse électriquement conductrice est à base d'élastomère conducteur comprenant l'un au moins des matériaux conducteurs suivants : carbone graphite, cuivre argenté, nickel, graphite nickelé, aluminium argenté ou polymères conducteurs tels que des polyacétylènes ou des polypyrroles.

3. Carte à puce selon la revendication 2, **caractérisée en ce que** l'élastomère de constitution de la mousse conductrice est un silicone ou un silicone fluoré.

4. Carte à puce selon l'une des revendications 1 à 3, **caractérisée en ce que** le plot (41) de mousse électriquement conductrice présente une épaisseur comprise entre 0,1 et 0,5mm.

5. Carte à puce selon l'une des revendications 1 à 4, **caractérisée en ce que** le plot (41) de mousse électriquement conductrice présente un diamètre compris entre 0,5 et 1,5 mm.

6. Carte à puce selon l'une des revendications 1 à 5, **caractérisée en ce que** le circuit électrique noyé dans le corps de carte est une antenne ou un circuit imprimé supportant au moins un autre composant électronique.

7. Procédé de fabrication d'une carte à puce comprenant un corps de carte (10, 50) dans lequel est encarté un module électronique électriquement connecté à un circuit électrique (20, 55) noyé dans ledit corps de carte, ledit procédé consistant à ménager une cavité (11, 12) dans le corps de carte, prévue pour y loger le module électronique, au-dessus de pistes de connexion (21, 55) dudit circuit électrique à interconnecter, ledit procédé étant **caractérisé en ce qu'il** consiste à reporter un plot (41) de mousse électriquement conductrice sur chaque piste de connexion (21, 55) dudit circuit électrique puis à reporter ledit module électronique dans sa cavité (11, 12) de sorte que ses plages de contact internes (32) soient électriquement reliées aux pistes de connexion (21, 55) du circuit électrique via les plots (41) de mousse conductrice.

8. Procédé selon la revendication 7, **caractérisé en ce que** préalablement au report du plot de mousse électriquement conductrice, le plot est prédécoupé dans un rectangle ou un cylindre de mousse conductrice.

9. Procédé selon l'une des revendications 7 à 8, **caractérisé en ce que** le plot de mousse conductrice est fixé sur les pistes de connexion du circuit électrique par l'un au moins des moyens suivants : apport de chaleur, dispense d'un adhésif électriquement conducteur ou fixation mécanique.
